# EUROPÄISCHE PATENTSCHRIFT

(11) **EP 3 437 142 B1**
(45) Veröffentlichungstag und Bekanntmachung des Hinweises auf die Patenterteilung: **06.04.2022**
(21) Anmeldenummer: 17714446.6
(22) Anmeldetag: 30.03.2017
(51) Int. Cl.: H01L 31/0236, H01L 31/036, H01L 31/18, H01L 21/306

(54) **VERFAHREN ZUM STRUKTURIEREN EINES SILIZIUMWAFERS**
METHOD FOR STRUCTURING A SILICON WAFER
PROCÉDÉ DE STRUCTURATION D'UNE PLAQUETTE DE SILICIUM

(30) Priorität: 31.03.2016 DE 102016105866
(43) Veröffentlichungstag der Anmeldung: 06.02.2019
(73) Patentinhaber: Technische Universität Bergakademie Freiberg, 09599 Freiberg (DE)
(72) Erfinder: STAPF, André, 09648 Altmittweida (DE); GONDEK, Christoph, 09599 Freiberg (DE); HONEIT, Florian, 09599 Freiberg (DE); KROKE, Edwin, 09633 Halsbrücke (DE)
(74) Vertreter: Viering, Jentschura & Partner mbB Patent- und Rechtsanwälte
(86) Internationale Anmeldenummer: PCT/EP2017/057524
(87) Internationale Veröffentlichungsnummer: WO 2017/167867

(56) Entgegenhaltungen:
- EP-A1- 0 477 424
- WO-A1-2013/053472
- WO-A2-2015/113890
- DE-A1-102007 026 081
- DE-B3-102014 001 363
- US-A- 4 137 123
- US-A1- 2002 079 290
- US-A1- 2015 068 594

## Beschreibung

Die Erfindung betrifft einen Siliziumwafer, ein Verfahren zum Strukturieren eines Siliziumwafers und eine Solarzelle.

Für eine hohe Effektivität einer Solarzelle ist eine hohe Lichtausbeute unerlässlich. Um dies zu erreichen, werden auf einem Siliziumwafer, welcher später zu einer Solarzelle prozessiert werden kann, spezielle Strukturen erzeugt. Dadurch kann beispielsweise erreicht werden, dass einfallendes Licht nach dem Auftreffen auf die Oberfläche des Siliziumwafers mehrmals auf diese zurück reflektiert wird. Für industriell gefertigte Solarzellen spielen zwei Strukturen eine Rolle: zufällig verteilte Gruben und zufällig verteilte Pyramiden. Für Hocheffizienzsolarzellen wird herkömmlicherweise eine Struktur basierend auf gleichmäßig verteilten inversen Pyramiden (d.h. pyramidenförmigen Ätzgruben) erzeugt.

Grubenstrukturen werden für multikristalline Solarzellen durch Behandeln des Siliziumwafers in einer salpetersäurehaltigen Flusssäurelösung generiert, welche zum Teil weitere Mineralsäuren oder weitere Oxidationsmittel (z.B. US 2003/0119332 A1) beinhalten kann. Teilweise werden zudem oberflächenaktive Substanzen zugesetzt, um die Benetzung der Siliziumoberfläche zu erhöhen (z.B.

US 2013/0130508 A1). Der Vorteil liegt dabei in der richtungsunabhängigen Erzeugung der Grubenstrukturen, sodass günstiger zu produzierendes multikristallines Material verwendet werden kann. Sie erzielen von den genannten Strukturen aber den geringsten Absorptionsgewinn. Die Effizienz der multikristallinen Solarzellen ist vergleichsweise gering.

Strukturen mit zufällig verteilten Pyramiden (engl. random pyramid layout; Green, High efficiency silicon solar cells. Aedermannsdorf: Trans Tech Publ., 1987; Wang, Wang, Highefficiency solar cells: Physics, materials, and devices. Cham: Springer, 2014) werden für monokristalline Solarzellen durch Behandeln der Siliziumwafer in Laugen (Kaliumhydroxid, Natriumhydroxid oder Tetramethylammoniumhydroxid) mit oberflächenaktiven Zusätzen (i-Propanol, Tenside) bei hohen Temperaturen (70 - 80 °C) erzeugt (DE 102008014166 B3; EP 2 605 289 A2). Alternativ können die Siliziumwafer in salzsäurehaltigen Flusssäurelösungen behandelt werden, denen ein Oxidationsmittel zugesetzt ist (DE102014001363B3). Diese Strukturen können nur auf einkristallinem Siliziummaterial mit der Kristallrichtung [100] erzeugt werden. Sie bieten den höchsten Absorptionsgewinn für industriell produzierbare Solarzellen.

Eine höhere Lichtausbeute bieten Strukturen basierend auf regelmäßig verteilten inversen Pyramidenstrukturen. Diese werden beispielsweise in aufwändigen Verfahren mit einer Vielzahl von Prozessschritten erzeugt, wobei auch eine Photolithographie erforderlich ist (DE000010350643B4). Dabei wird zunächst eine Ätzmaske auf die Siliziumwafer aufgebracht und anschließend wird der Siliziumwafer in einem anisotropen nasschemischen Ätzschritt behandelt. In einem weiteren Prozessschritt wird die Ätzmaske wieder entfernt. Auf Grund des hohen Aufwandes ist dieser Prozess für die Photovoltaik industriell nicht relevant und wird lediglich im Labormaßstab verwendet.

Der Gegenstand der Erfindung ist in Anspruch 1 definiert. Gemäß verschiedenen Ausführungsformen wird ein Verfahren bereitgestellt, welches geeignet ist, eine antireflektierende Oberfläche auf monokristallinen oder quasimonokristallinen (100) Siliziumwafern durch geeignete Ätzprozesse zu erzeugen, wobei die antireflektierende Oberfläche eine höhere Lichtausbeute als konventionelle Oberfläche mit zufälligen Pyramidenstrukturen aufweist. Dabei ist das Verfahren derart ausgestaltet, z.B. sind die Ätzprozesse einfach gehalten, dass das Verfahren ohne Aufwand mittels herkömmlichen Industrieätzanlagen ausgeführt werden kann.

Verschiedene Ausführungsformen basieren beispielsweise auf der Erkenntnis, dass ein Ätzverfahren für {100}-orientierte Siliziumoberflächen gefunden wurde, womit eine Struktur aus einer zufälligen Anordnung von inversen Pyramiden erzeugt werden kann. Anschaulich wurde ein Verfahren entwickelt, mittels dessen eine hocheffiziente antireflektierende {100}-orientierte Siliziumoberfläche auf einfache Weise hergestellt werden kann, d.h. beispielsweise ohne dass eine Photolithographie oder andere Maskenstrukturierung notwendig ist.

Gemäß verschiedenen Ausführungsformen wird eine Oberflächenstruktur geätzt, welche auf einer zufälligen Anordnung von inversen Pyramiden bzw. pyramidenförmigen Ätzgruben basiert. Die inversen Pyramiden können dabei beispielsweise verschiedene Kantenlängen und/oder verschiedene Tiefen aufweisen. Auch kann die Anordnung der inversen Pyramiden zufällig sein, z.B. kann jeweils der Abstand einander benachbarter inverser Pyramiden variieren (z.B. gemessen von Spitze zu Spitze).

Die Kantenlängen können beispielsweise in einem Bereich von ungefähr 0,1 µm bis ungefähr 20 µm variieren. Somit kann eine mittlere Kantenlänge in einem Bereich von ungefähr 0,1 µm bis ungefähr 20 µm liegen. Die Kantenlängen können dabei entlang einer Richtung parallel zur {100}-orientierten Oberfläche des Siliziumwafers gemessen werden, d.h. dass die Kantenlängen von den jeweiligen Grundflachen der inversen Pyramiden definiert sind.

Die Ätzgruben können auch von der Form einer idealen inversen Pyramide abweichen, jedoch im Wesentlichen dieser Form ähnlich sein. Beispielsweise können die Ätzgruben auch die Form eines (halben) Tetraederstumpfs aufweisen. Gemäß verschiedenen Ausführungsformen werden Ätzgruben erzeugt, wobei deren Form auch von der Kristallstruktur des Siliziums definiert ist.

Mittels des hierin beschriebenen Verfahrens kann ein Siliziumwafer erzeugt werden, dessen Oberfläche antireflektierend ist basierend auf der hierin beschrieben zufälligen Anordnung von Ätzgruben, z.B. in Form einer zufälligen Anordnung von inversen Pyramiden auf der freiliegenden Oberfläche des Siliziumwafers.

Gemäß verschiedenen Ausführungsformen kann ein Siliziumwafer folgendes aufweisen: eine {100}-orientierte Oberfläche, wobei die Oberfläche eine Oberflächenstruktur aus einer Vielzahl von zufällig verteilten Vertiefungen aufweist, wobei die Vertiefungen polyederförmig sind. Insbesondere kann ein Siliziumwafer folgendes aufweisen: eine {100}-orientierte Oberfläche, wobei die Oberfläche eine unregelmäßige Oberflächenstruktur aus einer Vielzahl von (z.B. zufällig verteilten und/oder zufällig großen) pyramidenförmigen Ätzgruben aufweist.

Gemäß verschiedenen Ausführungsformen kann der Siliziumwafer monokristallin oder quasi-monokristallin sein.

Die polyederförmigen Vertiefungen können jeweils zumindest zwei dreieckige Seitenflächen aufweisen.

Gemäß verschiedenen Ausführungsformen können die Vertiefungen pyramiden-förmig sein. Dabei weisen die Vertiefungen jeweils vier dreieckige Seitenflächen auf. Anschaulich kann sich die Form der Vertiefungen aus der Kristallstruktur der Siliziumoberfläche ergeben.

Die Vertiefungen können beispielsweise bezüglich des Orts auf der Oberfläche zufällig verteilt sein. Die Vertiefungen können beispielsweise bezüglich deren Breite und/oder Tiefe zufällig verteilt sein. Auch können die Vertiefungen sowohl bezüglich des Orts auf der Oberfläche als auch bezüglich deren Breite und/oder Tiefe zufällig verteilt sein.

Gemäß verschiedenen Ausführungsformen können die Vertiefungen an der Oberfläche des Siliziumwafers im arithmetischen Mittel eine Breite in einem Bereich von ungefähr 0,1 µm bis ungefähr 20 µm aufweisen. Beispielsweise können die Vertiefungen an der Oberfläche des Siliziumwafers jeweils eine Breite in einem Bereich von ungefähr 0,1 µm bis ungefähr 20 µm aufweisen.

An der Oberfläche des Siliziumwafers definieren die Vertiefungen jeweils eine Grundfläche. Die Außenkontur der Grundfläche wird von dem Silizium der Waferoberfläche definiert. Bei polyederförmigen Vertiefungen kann eine Grundfläche ein Polygon mit jeweils nur gleichen Kantenlängen sein (z.B. bei einer quadratischen Grundfläche), wobei als Breite der Vertiefungen die Kantenlänge der Grundfläche angesehen werden kann. Alternativ kann die Grundfläche verschiedene Kantenlängen aufweisen (z.B. bei einer rechteckigen Grundfläche), wobei als Breite der polyederförmigen Vertiefungen die längste Kantenlänge der Grundfläche angesehen werden kann.

Gemäß verschiedenen Ausführungsformen kann sich die Vertiefung mit zunehmender Tiefe verjüngen, d.h. anschaulich bei polygonaler (z.B. quadratischer) Grundfläche an der Oberfläche invers pyramidenförmig sein.

Bei pyramidenförmigen Vertiefungen kann die Grundfläche der inversen Pyramide die Breite der Vertiefung an der Oberfläche des Siliziumwafers definieren, z.B. kann die Kantenlänge (oder eine maximale Kantenlänge) der Grundfläche der invers pyramidenförmigen Vertiefungen als Breite angesehen werden. Gemäß verschiedenen Ausführungsformen können die Vertiefungen im arithmetischen Mittel eine Tiefe in einem Bereich von ungefähr 0,1 µm bis ungefähr 20 µm aufweisen. Beispielsweise können die Vertiefungen eine Tiefe in einem Bereich von ungefähr 0,1 µm bis ungefähr 20 µm aufweisen.

Gemäß verschiedenen Ausführungsformen kann die Anzahl der Vertiefungen pro Quadratmillimeter größer als 500 sein, z.B. größer als ungefähr 1000, 1500 oder 2000. Anschaulich kann eine lichtabsorbierende Oberfläche aus strukturgeätztem Silizium bereitgestellt sein oder werden, welche eine ausreichend dichte unregelmäßige Oberflächenstruktur aus Vertiefungen aufweist. Beispielsweise kann eine derartige Oberflächenstruktur Licht optimal absorbieren, z.B. können Interferenzen und andere wellenlängenabhängige Einflüsse vermieden oder reduziert werden. Auch kann zur optimalen Lichtabsorption eine gewisse Strukturgröße (z.B. Breite und/oder Tiefe) notwendig sein, wie hierin beschrieben ist. Gemäß verschiedenen Ausführungsformen kann der Reflexionsgrad der strukturierten Oberfläche des Siliziumwafers geringer als 0,25 oder geringer als 0,20 oder geringer als 0,15 sein. Gemäß verschiedenen Ausführungsformen kann ein Verfahren zum Strukturieren einer {100}-orientierten Oberfläche eines Siliziumwafers Folgendes aufweisen: Platzieren des Siliziumwafers in einer Ätzlösung; Erzeugen einer Strömung der Ätzlösung relativ zu der {100}-orientierten Oberfläche des Siliziumwafers derart, dass eine Oberflächenstruktur aus einer Vielzahl von zufällig verteilten Vertiefungen geätzt wird, wobei die Vertiefungen polyederförmig (z.B. pyramidenförmig) sind, wobei die Ätzlösung Flusssäure und Salzsäure enthält sowie ein Oxidationsmittel. Das Oxidationsmittel kann beispielsweise mindestens eines aus der folgenden Gruppe von Oxidationsmitteln aufweisen oder sein: Wasserstoffperoxid; Chlor (in Wasser beispielsweise als Gleichgewicht aus Chlor, hypochloriger Säure und Salzsäure vorliegend); Kupferionen (z.B. zugegeben als Kupfersalz, wie beispielsweise Kupfersulfat) .

Gemäß verschiedenen Ausführungsformen kann die Strömung mittels Rührens der Ätzlösung erzeugt werden. Ferner kann die Strömung mittels Einleitens eines Gases in die Ätzlösung erzeugt werden. Auch kann die Strömung gleichzeitig mittels Rührens der Ätzlösung und mittels Einleitens eines Gases in die Ätzlösung erzeugt werden

Gemäß verschiedenen Ausführungsformen kann die Oberfläche des Siliziumwafers während des Ätzens frei liegen, d.h. beispielsweise nicht teilweise mit Lack bedeckt sein oder anderweitig maskiert sein. Somit kann ein kostengünstiges Verfahren zum Erzeugen einer lichtabsorbierenden Siliziumoberfläche bereitgestellt sein oder werden, welches Lithographie-Prozesse vermeidet, die herkömmlicherweise in der Halbleiterindustrie verwendet werden.

Gemäß verschiedenen Ausführungsformen kann eine Solarzelle Folgendes aufweisen: einen Siliziumwafer wie hierin beschrieben ist (z.B. aufweisend eine Oberflächenstruktur aus einer Vielzahl von zufällig verteilten polyederförmigen oder pyramidenförmigen Vertiefungen auf einer {100}-orientierten Oberfläche des Siliziumwafers), wobei die Oberflächenstruktur als Lichteinfallseite der Solarzelle bereitgestellt ist. Ferner kann der Siliziumwafer mindestens einen p-n-Übergang aufweisen. Ferner kann die Solarzelle eine Vorderseitenmetallisierung zum elektrischen Kontaktieren der Lichteinfallsseite des Siliziumwafers und eine Rückseitenmetallisierung zum elektrischen Kontaktieren einer der Lichteinfallsseite gegenüberliegenden Rückseite des Siliziumwafers aufweisen.

Ausführungsbeispiele der Erfindung sind in den Figuren dargestellt und werden im Folgenden näher erläutert.

Es zeigen
- Figuren 1A bis 1C: herkömmliche Oberflächenstrukturen von Siliziumwafern;
- Figuren 2A und 2B: jeweils eine schematische Ansicht einer Oberflächenstruktur eines Siliziumwafers, gemäß verschiedenen Ausführungsformen;
- Figuren 3A und 3B: jeweils eine Abbildung einer Oberflächenstruktur eines Siliziumwafers, gemäß verschiedenen Ausführungsformen;
- Figur 4: ein schematisches Ablaufdiagramm eines Verfahrens zum Strukturieren eines Siliziumwafers, gemäß verschiedenen Ausführungsformen;
- Figuren 5A, 5B und 5C: jeweils einen schematischen Aufbau einer Anordnung zum Durchführen des Verfahrens zum Strukturieren eines Siliziumwafers, gemäß verschiedenen Ausführungsformen; und
- Figur 6: einen schematischen Aufbau einer Solarzelle, gemäß verschiedenen Ausführungsformen.

In der folgenden ausführlichen Beschreibung wird auf die beigefügten Zeichnungen Bezug genommen, die Teil dieser bilden und in denen zur Veranschaulichung spezifische Ausführungsformen gezeigt sind, in denen die Erfindung ausgeübt werden kann. Es versteht sich, dass andere Ausführungsformen benutzt und strukturelle oder logische Änderungen vorgenommen werden können, ohne von dem Schutzumfang der vorliegenden Erfindung abzuweichen. Es versteht sich, dass die Merkmale der hierin beschriebenen verschiedenen beispielhaften Ausführungsformen miteinander kombiniert werden können, sofern nicht spezifisch anders angegeben. Die folgende ausführliche Beschreibung ist deshalb nicht in einschränkendem Sinne aufzufassen, und der Schutzumfang der vorliegenden Erfindung wird durch die angefügten Ansprüche definiert.

In den Figuren werden identische oder ähnliche Elemente mit identischen Bezugszeichen versehen, soweit dies zweckmäßig ist.

Gemäß verschiedenen Ausführungsformen werden ein Verfahren zum Strukturieren eines Siliziumwafers und ein Siliziumwafer bereitgestellt, wobei die Oberfläche des Siliziumwafers derart strukturiert ist bzw. wird, dass diese Licht optimal absorbieren kann. Somit kann der Siliziumwafer bzw. das Verfahren zum Strukturieren des Siliziumwafers in der Photovoltaik-Industrie verwendet werden, beispielsweise zum Bereitstellen einer hocheffizienten Solarzelle.

Gemäß verschiedenen Ausführungsformen wird der Siliziumwafer mindestens einem nasschemischen Ätzschritt unterzogen.

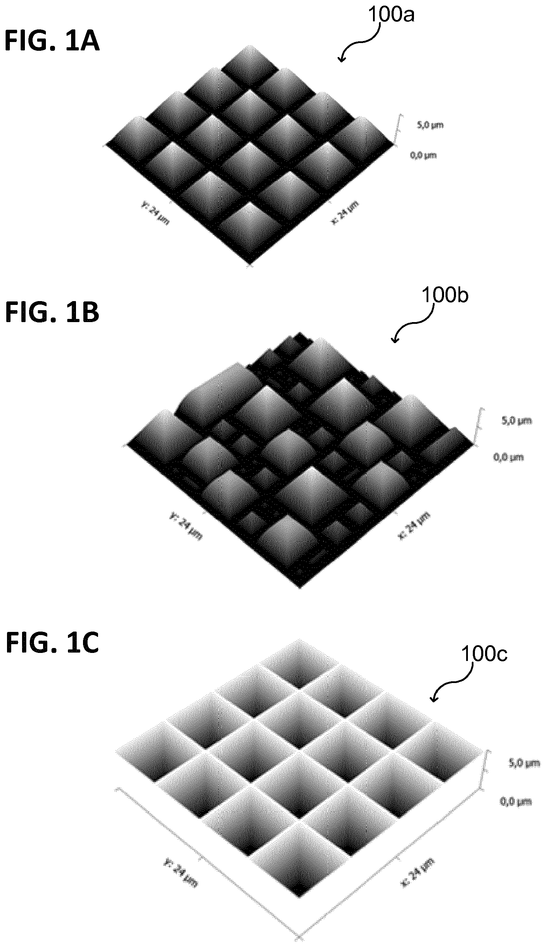

In die Figuren 1A bis 1C sind Ätzstrukturen dargestellt, wie sie herkömmlicherweise auf einer Oberfläche eines Siliziumwafers gebildet werden.

**Fig.1A** zeigt eine Ätzstruktur 100a basierend auf einer regelmäßigen Anordnung von quadratischen Pyramiden. Die heller dargestellten Spitzen der Pyramiden sind bei dieser Ätzstruktur vom Wafer weg gerichtet. Ferner sind alle Pyramiden gleich groß, d.h. alle Pyramiden haben die gleiche Kantenlänge der Grundflächen und die gleiche Höhe. Ferner sind die Pyramiden relativ zueinander in senkrecht zueinander stehenden Reihen und Spalten symmetrisch angeordnet.

**Fig.1B** zeigt eine Ätzstruktur 100b basierend auf einer unregelmäßigen Anordnung von Pyramiden. Die heller dargestellten Spitzen der Pyramiden sind bei dieser Ätzstruktur vom Wafer weg gerichtet. Die Pyramiden sind unterschiedlich groß, d.h. die Pyramiden haben unterschiedliche Kantenlängen der Grundflächen und/oder unterschiedliche Formen der Grundflächen und/oder unterschiedliche Höhen. Ferner sind die Pyramiden relativ zueinander nicht symmetrisch in Reihen und Spalten angeordnet.

Anhand von Fig.1A und Fig.1B sind beispielhaft anhand pyramidenförmiger Ätzstrukturen wesentliche Unterschiede dargestellt, welche eine regelmäßige von einer unregelmäßigen Ätzstruktur unterscheiden. Gleiches gilt in analoger Weise für Formen, die entsprechend von der Form einer Pyramide abweichen.

**Fig.1C** zeigt eine Ätzstruktur 100c basierend auf einer regelmäßigen Anordnung von inversen Pyramiden. Eine derartige regelmäßige Anordnung wird dadurch erzeugt, dass der Siliziumwafer mittels einer photolithographisch erzeugten Maske geätzt wird. Die dunkler dargestellten Spitzen der inversen Pyramiden sind bei dieser Ätzstruktur in den Wafer hinein gerichtet. Ferner sind alle inversen Pyramiden gleich groß, d.h. alle inversen Pyramiden haben die gleiche Kantenlänge der Grundflächen und die gleiche Tiefe. Ferner sind die Pyramiden relativ zueinander in senkrecht zueinander stehenden Reihen und Spalten symmetrisch angeordnet.

Siliziumwafer können im Allgemeinen mit alkalischen Medien, wie z.B. wässrigen Kaliumhydroxid-, Natriumhydroxid- oder Tetramethylammoniumhydroxid-Lösungen, behandelt werden. Aufgrund der Kristallstruktur des Siliziums werden Siliziumatome verschiedener Kristallebenen unterschiedlich schnell abgetragen, d.h. der Ätzvorgang erfolgt anisotrop. Diese Anisotropie hat beim Ätzen unterschiedlich orientierter Siliziumwafer folgende Auswirkungen: Silizium(111)-Oberflächen werden kaum angegriffen; auf Silizium(100)-Oberflächen werden Pyramiden mit quadratischer Grundfläche gebildet, siehe Fig.1B, die z.B. bei Silizium-Solarzellen die Lichtreflexion reduzieren; und auf Silizium(110)-Oberflächen entstehen rechtwinklige Gräben, wie sie in der Mikromechanik und Mikrofluidik Anwendung finden.

Gemäß verschiedenen Ausführungsformen wurde eine Möglichkeit gefunden, eine Oberflächenstruktur mittels eines anisotropen Ätzprozesses bereitzustellen, wobei die Oberflächenstruktur aus inversen Pyramiden aufgebaut ist.

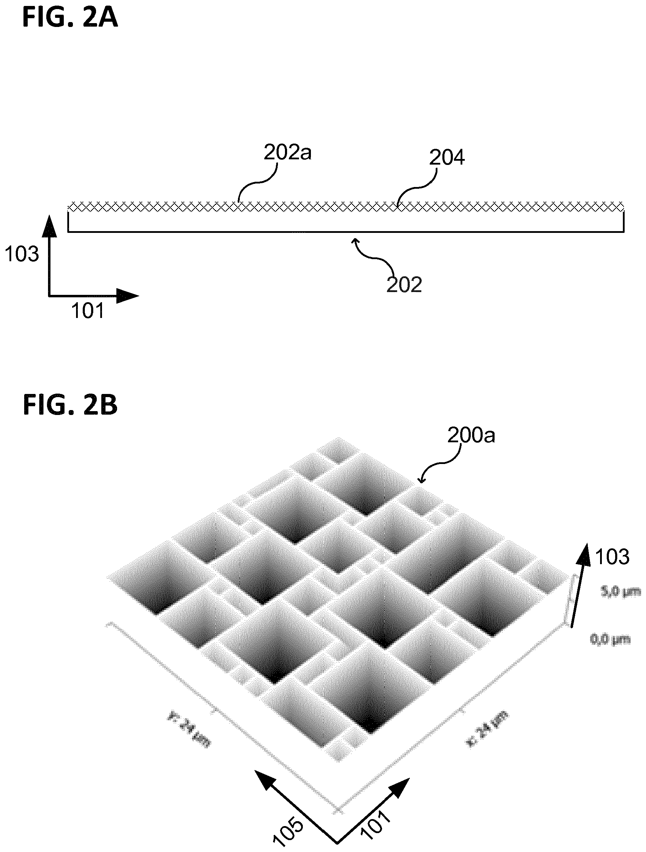

**Fig.2A** veranschaulicht einen Siliziumwafer 202 in einer schematischen Seiten- oder Querschnittsansicht, wobei der Siliziumwafer eine Oberflächenstruktur 204 basierend auf einer Vielzahl von zufällig verteilten Vertiefungen aufweist, gemäß verschiedenen Ausführungsformen.

Der Siliziumwafer 202 weist eine {100}-orientierte Oberfläche 202a auf oder mit anderen Worten, die {100}-orientierte Oberfläche 202a des Siliziumwafers 202 wurde mittels einer Ätzlösung derart behandelt, dass auf dieser Oberfläche 202a die Oberflächenstruktur 204 gebildet wird. In dem in Fig.2A dargestellten Fall liegt die {100}-Oberfläche 202a des Siliziumwafers 202 parallel zur Richtung 101.

**Fig.2B** veranschaulicht eine Draufsicht auf den Siliziumwafer 202 in einer schematischen perspektivischen Ansicht, gemäß verschiedenen Ausführungsformen. Dabei ist eine Ätzstruktur 200a veranschaulicht, welche auf einer unregelmäßigen Anordnung von inversen Pyramiden basiert, gemäß verschiedenen Ausführungsformen. Die inversen Pyramiden können eine quadratische oder rechteckige (oder allgemein eine n-eckige) Grundfläche aufweisen. Die dunkler dargestellten Spitzen der inversen Pyramiden sind bei dieser Ätzstruktur in den Wafer hinein gerichtet. Die inversen Pyramiden sind beispielsweise unterschiedlich groß, d.h. die inversen Pyramiden haben unterschiedliche Kantenlängen der Grundflächen und/oder unterschiedliche Formen der Grundflächen und/oder unterschiedliche Tiefen. Ferner sind die Pyramiden relativ zueinander nicht symmetrisch in Reihen und Spalten zueinander angeordnet.

Anhand von Fig.2B ist eine unregelmäßige Ätzstruktur anhand des Beispiels von inversen Pyramiden dargestellt. Gleiches gilt in analoger Weise für Formen, die entsprechend von der Form einer inversen Pyramide abweichen. Gemäß verschiedenen Ausführungsformen können Vertiefungen die Form von Polyedern aufweisen, die einer inversen Pyramide ähnlich sind. Dies können Vertiefungen sein, die beispielsweise jeweils zumindest zwei dreieckige Seitenflächen aufweisen. Ferner können dies Vertiefungen sein, die beispielsweise jeweils zwei dreieckige Seitenflächen und zwei trapezförmige Seitenflächen aufweisen (z.B. in Form eines halben Tetraederstumpfs). Ferner können dies Vertiefungen sein, die vier dreieckige Seitenflächen aufweisen, wobei die dreieckigen Seitenflächen nicht alle kongruent sein müssen.

Wie in Fig.2B veranschaulicht ist, sind die inversen Pyramiden in der von den Richtungen 101 und 105 aufgespannten Ebene (parallel zur Oberfläche 202a des Siliziumwafers 202) unregelmäßig bzw. zufällig angeordnet. Anschaulich sind die Vertiefungen der Ätzstruktur bezüglich des Orts auf der Oberfläche zufällig verteilt. Um diese Verteilung zu charakterisieren, können die Spitzen der inversen Pyramiden betrachtet werden. Diese sind nicht wie bei einer regelmäßigen Ätzstruktur, vgl. Fig.1A und 1C, entlang zweier orthogonaler Richtungen angeordnet. Aufgrund der Kristallstruktur des Siliziumwafers 202 können die Kanten der Grundflächen der inversen Pyramiden entlang zweier Vorzugsrichtungen 101, 105 ausgerichtet sein. Entlang dieser Richtungen können beispielsweise die Kantenlängen der Grundflächen der inversen Pyramiden ermittelt werden.

Wie beispielhaft in Fig.2B veranschaulicht ist, können die Vertiefungen nicht nur bezüglich deren Ort auf der Waferoberfläche sondern auch bezüglich deren Breite (d.h. Kantenlängen bzw. Größe der Grundflächen) und/oder deren Tiefe zufällig verteilt sein.

Eine derartige zufällige bzw. unregelmäßige Oberflächenstruktur kann einfallendes Licht optimal absorbieren.

Im Gegensatz zu einer Ätzstruktur bestehend aus Pyramiden sind bei der Ätzstruktur bestehend aus inversen Pyramiden die jeweiligen Vertiefungen umlaufend von Silizium gebildet sind. Anschaulich liegen nicht die Spitzen der Pyramiden frei sondern deren Rand der Grundflächen, siehe Fig.2B. Somit ergibt sich eine Art Kantennetz an der Oberfläche 202a des Siliziumwafers 202 nachdem die inversen Pyramiden geätzt wurden.

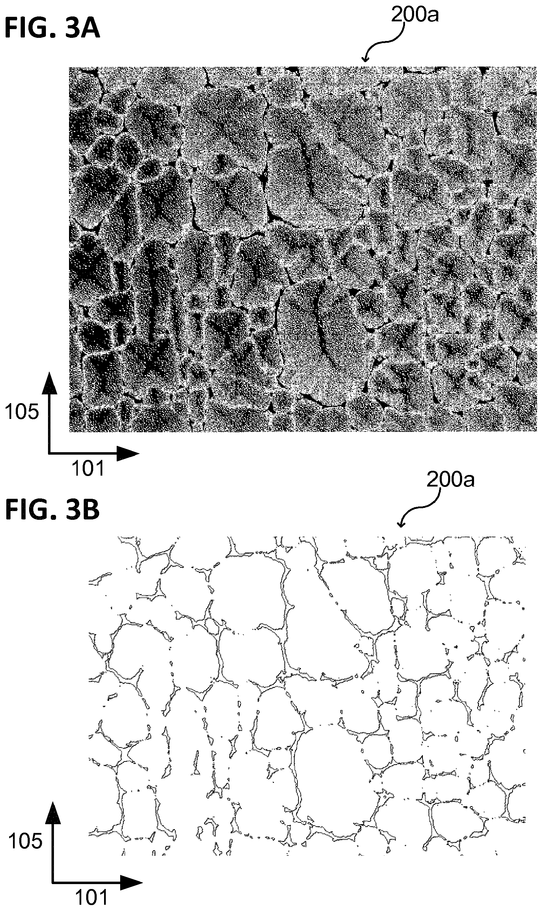

Es versteht sich, dass sich die geätzten Strukturen von der in Fig.2B dargestellten idealen Struktur unterscheiden können. In **Fig.3A** ist eine unregelmäßige Ätzstruktur 200a basierend auf inversen Pyramiden beispielhaft dargestellt, wobei in **Fig.3B** das entsprechende Kantennetz veranschaulicht ist, welches sich an der der Oberfläche 202a des Siliziumwafers 202 gebildet hat. In der Darstellung von Fig.3A sind die tieferliegenden Stellen dunkler dargestellt. Man erkennt die zufällig verteilten pyramidenförmigen bzw. polyederförmigen Vertiefungen in der Oberfläche des Siliziumwafers 202.

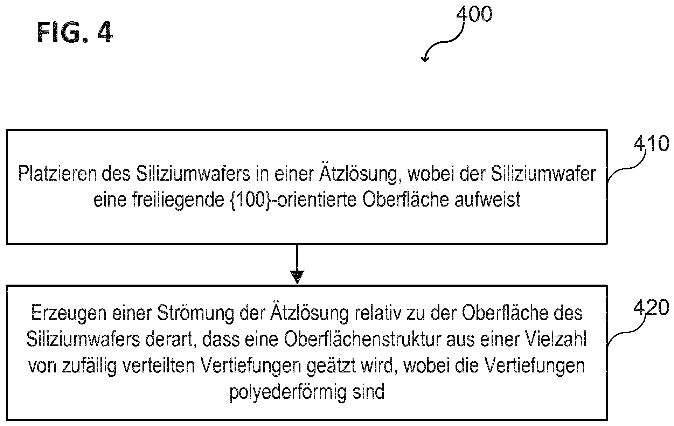

In **Fig.4** ist ein schematisches Ablaufdiagramm eines Verfahrens 400 zum Strukturieren eines Siliziumwafers 202 dargestellt, wobei das Verfahren 400 Folgendes aufweist: in 410, das Platzieren des Siliziumwafers 202 in einer Ätzlösung, wobei der Siliziumwafer 202 eine freiliegende {100}-orientierte Oberfläche 202a aufweist; und, in 420, das Erzeugen einer Strömung der Ätzlösung relativ zu der Oberfläche 202a des Siliziumwafers 202 derart, dass eine Oberflächenstruktur 204 aus einer Vielzahl von zufällig verteilten Vertiefungen geätzt wird, wobei die Vertiefungen polyederförmig sind (z.B. in Form von pyramidenförmigen Ätzgruben, wie hierin beschrieben ist).

Das Ätzen des Siliziumwafers 202 erfolgt unter Verwendung einer Ätzlösung, welche Flusssäure, Salzsäure und mindestens ein zugesetztes Oxidationsmittel aufweist. Als Oxidationsmittel können/kann beispielsweise Wasserstoffperoxid (H₂O₂), gasförmiges Chlor (Cl₂) und/oder Kupferionen (Cu²⁺), verwendet werden. Dabei kann die hierin beschrieben Oberflächenstruktur 204 dadurch erzeugt werden, dass die Ätzlösung während des Ätzprozesses in Strömung versetzt wird.

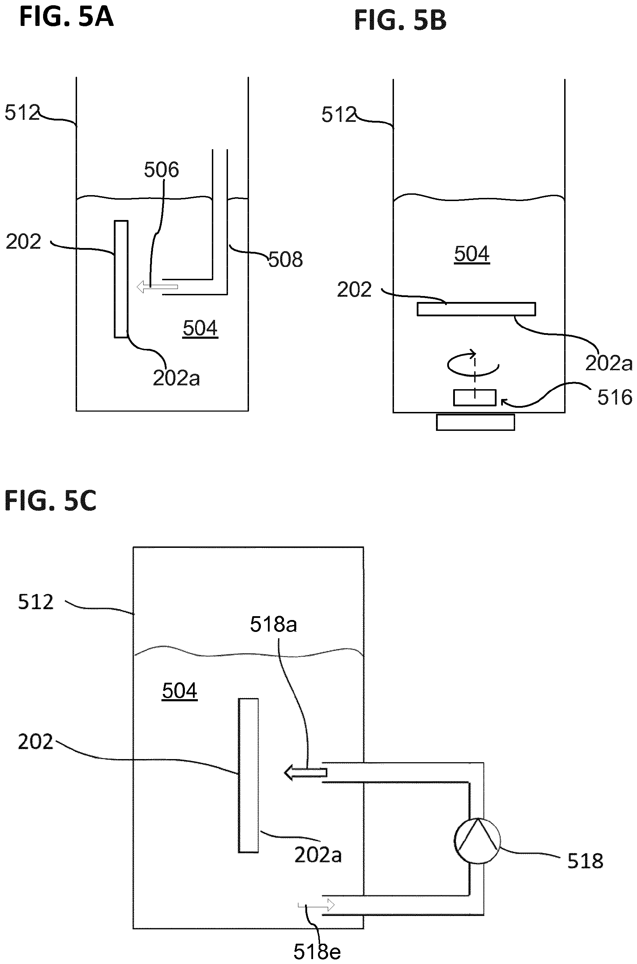

Die Strömung kann auf beliebige Weise erzeugt werden, beispielsweise mittels Einleitens eines Gasstroms 506 in die Ätzlösung 504, wie beispielhaft in **Fig.5A** veranschaulicht ist, mittels Rührens der Ätzlösung 504, wie beispielhaft in **Fig.5B** veranschaulicht ist, und/oder mittels Umwälzens 518 der Ätzlösung 504, wie beispielhaft in **Fig.5C** veranschaulicht ist. Die Ätzlösung 504 kann beispielsweise in einem PFA-(Perfluoralkoxy-Copolymer)-Behälter 512 aufgenommen sein oder in einem anderen geeigneten Behälter.

Wie in Fig.5A dargestellt ist, kann ein Gasstrom 506 mittels einer Zuleitung 508 direkt in die Ätzlösung 504 eingeleitet werden. Somit kann die Ätzlösung 504 an der freiliegenden Oberfläche 202a des in die Ätzlösung 504 eingetauchten Siliziumwafers 202 vorbei strömen. Auf der freiliegenden Oberfläche 202a des in die Ätzlösung 504 eingetauchten Siliziumwafers 202 wird somit die Ätzstruktur 204 gebildet, wie sie vorangehend beschrieben ist.

Als Gas zum Einleiten in die Ätzlösung können/kann beispielsweise Chlor, Argon und/oder Sauerstoff verwendet werden. Die Zuleitung 508 kann derart relativ zu dem in der Ätzlösung 504 platzierten Siliziumwafer 202 angeordnet sein, dass die Gasaustrittsöffnung der Zuleitung 508 in einem Abstand von ungefähr 2 cm bis ungefähr 5 cm vom Siliziumwafer 202 angeordnet ist.

Wie in Fig.5B dargestellt ist, kann die Ätzlösung 504 auch mittels eines Rührers 516, z.B. eines Magnet-Rührers, in Strömung versetzt werden, oder auf eine sonstige bekannte Art und Weise. Somit kann die Ätzlösung 504 an der freiliegenden Oberfläche 202a des in die Ätzlösung 504 eingetauchten Siliziumwafers 202 vorbei strömen. Auf der freiliegenden Oberfläche 202a des in die Ätzlösung 504 eingetauchten Siliziumwafers 202 wird somit die Ätzstruktur 204 gebildet, wie sie vorangehend beschrieben ist.

Wie in Fig.5C dargestellt ist, kann die Ätzlösung 504 auch mittels einer Pumpe 518, z.B. einer Umwälzpumpe, in Strömung versetzt werden, oder auf eine andere bekannte Art und Weise. Mittels der Pumpe 518 und entsprechenden Leitungen kann beispielsweise Ätzlösung 504 entfernt vom eingetauchten Siliziumwafer 202 eingesaugt werden 518e und die eingesaugte Ätzlösung 504 kann in Richtung des Siliziumwafers 202 gepumpt werden 518a. Somit kann die Ätzlösung 504 an der freiliegenden Oberfläche 202a des in die Ätzlösung 504 eingetauchten Siliziumwafers 202 vorbei strömen. Auf der freiliegenden Oberfläche 202a des in die Ätzlösung 504 eingetauchten Siliziumwafers 202 wird somit die Ätzstruktur 204 gebildet, wie sie vorangehend beschrieben ist.

Anschaulich wird der zu behandelnde Siliziumwafer in der strömenden Ätzlösung 504 platziert. Dabei kann er auf beliebige Art und Weise gelagert werden, z.B. kann der Siliziumwafer 202 mittels eines Greifers in der Ätzlösung 504 gehalten werden. Dabei kann die freiliegende zu prozessierende (100)-orientierte Oberfläche 202a des Siliziumwafers 202 entsprechend von der strömenden Ätzlösung 504 geätzt werden, wobei die Ätzstruktur 204 basierend auf inversen Pyramiden gebildet wird. Aufgrund der sich relativ zur Oberfläche bewegenden Ätzlösung 504 wird die erzeugte Ätzstruktur beeinflusst, wobei ohne die Ätzlösung 504 in Strömung zu versetzten eine andere Ätzstruktur gebildet werden würde, z.B. eine Ätzstruktur basierend auf Pyramiden wie in Fig.1B dargestellt ist.

Ein Photolithographie-Prozessschritt wie bei der in Fig.1C beschriebenen Oberflächenstruktur ist nicht notwendig. Dadurch ist der hierin beschriebene Ätzprozess ohne Aufwand in Industrieätzanlagen implementierbar. Das Verfahren 400 kann preiswert und einfach großtechnisch angewendet werden, z.B. zur Herstellung von Photovoltaik-Zellen.

Gemäß verschiedenen Ausführungsformen wurde gefunden, dass bei der Verwendung von wässrigen Gemischen aus Flusssäure (HF), Salzsäure (HCl) und einem zugesetzten Oxidationsmittel bei der Behandlung von monokristallinen Silizium(100)-Wafern inverse Pyramiden mit beispielsweise quadratischer Grundfläche erzeugt werden können, wenn das jeweilige Gemisch während des Ätzprozesses in Strömung versetzt wird.

Im Folgenden werden beispielhaft einige Ätzlösung 504 beschrieben, mittels derer die Oberflächenstruktur 204 aus einer Vielzahl von zufällig verteilten polyederförmigen Vertiefungen hergestellt werden kann.

Gemäß einem ersten Beispiel, kann die Ätzmischung (d.h. die Ätzlösung 504) Folgendes aufweisen:
- Flusssäure (HF), z.B. mit einer Konzentration von 5,0 mol/L,
- Salzsäure (HCl), z.B. mit einer Konzentration von 2,0 mol/L), und
- als Oxidationsmittel Kupferionen (Cu2+), z.B. bereitgestellt durch Zugabe von Kupfer(II)sulfat (CuSO₄), mit einer Konzentration von 0,1 mol/L.

Diese Ätzlösung 504, in welcher der Siliziumwafer 202 platziert wurde, wurde durch Rühren, z.B. mit einer Rotationsgeschwindigkeit von ungefähr 200 Umdrehungen pro Minute, in Strömung versetzt (siehe Fig.5B). Die gebildete Ätzstruktur 204 weist zufällig angeordnete inverse Pyramiden mit Kantenlängen in einem Bereich von ungefähr 0,5 µm bis ungefähr 15 µm auf.

Gemäß einem zweiten Beispiel, kann die Ätzmischung (d.h. die wässrige Ätzlösung 504) Folgendes aufweisen:
- Flusssäure (HF), z.B. mit einer Konzentration von 5,0 mol/L,
- Salzsäure (HCl), z.B. mit einer Konzentration von 2,0 mol/L), und
- als Oxidationsmittel Kupferionen (Cu²⁺), z.B. bereitgestellt durch Zugabe von Kupfer(II)sulfat (CuSO₄), mit einer Konzentration von 0,1 mol/L.

Diese Ätzlösung 504, in welcher der Siliziumwafer 202 platziert wurde, wurde durch kontinuierliches Zuführen von Sauerstoffgas (O₂) in Strömung versetzt (siehe Fig.5A). Die gebildete Ätzstruktur 204 weist zufällig angeordnete inverse Pyramiden mit Kantenlängen in einem Bereich von ungefähr 0,5 µm bis ungefähr 15 µm auf.

Gemäß einem dritten Beispiel, kann die Ätzmischung (d.h. die wässrige Ätzlösung 504) Folgendes aufweisen:
- Flusssäure (HF), z.B. mit einer Konzentration von 0,2 mol/L,
- Salzsäure (HCl), z.B. mit einer Konzentration von 11,7 mol/L), und
- als Oxidationsmittel Wasserstoffperoxid (H₂O₂), z.B. mit einer Konzentration von 0,2 mol/L.

Diese Ätzlösung 504, in welcher der Siliziumwafer 202 platziert wurde, wurde durch Rühren, z.B. mit einer Rotationsgeschwindigkeit von ungefähr 150 Umdrehungen pro Minute, in Strömung versetzt (siehe Fig.5B). Die gebildete Ätzstruktur 204 weist zufällig angeordnete inverse Pyramiden mit Kantenlängen in einem Bereich von ungefähr 0,1 µm bis ungefähr 10 µm auf.

Gemäß einem vierten Beispiel, kann die Ätzmischung (d.h. die wässrige Ätzlösung 504) Folgendes aufweisen:
- Flusssäure (HF), z.B. mit einer Konzentration von 5,5 mol/L,
- Salzsäure (HCl), z.B. mit einer Konzentration 9,6 mol/L), und
- als Oxidationsmittel Chlor (Cl₂).

Das Oxidationsmittel Chlor wurde dadurch bereitgesellt, dass Chlorgas in die wässrige Ätzlösung 504 eingeleitet wurde. Dabei wurde die Ätzlösung 504 durch ein kontinuierliches Zuführen von Chlorgas (Cl₂) in Strömung versetzt. Die gebildete Ätzstruktur 204 weist zufällig angeordnete inverse Pyramiden mit Kantenlängen in einem Bereich von ungefähr 1 µm bis ungefähr 20 µm auf.

Gemäß einem fünften Beispiel, kann die Ätzmischung (d.h. die wässrige Ätzlösung 504) Folgendes aufweisen:
- Flusssäure (HF), z.B. mit einer Konzentration von 1,4 mol/L,
- Salzsäure (HCl), z.B. mit einer Konzentration 9,6 mol/L), und
- als Oxidationsmittel Chlor (Cl₂).

Diese Ätzlösung 504, in welcher der Siliziumwafer 202 platziert wurde, wurde durch Rühren, z.B. mit einer Rotationsgeschwindigkeit von ungefähr 150 Umdrehungen pro Minute, in Strömung versetzt (siehe Fig.5B). Die gebildete Ätzstruktur 204 weist zufällig angeordnete inverse Pyramiden mit Kantenlängen in einem Bereich von ungefähr 0,1 µm bis ungefähr 20 µm auf.

Gemäß verschiedenen Ausführungsformen kann die Ätzlösung 504 folgende Konzentrationen an Flusssäure, Salzsäure und Oxidationsmittel enthalten:
- c(HF) = 0,1 bis 10 mol/L,
- c(HCl) = 1 bis 12 mol/L und
- c(Oxidationsmittel) = 0,05 bis 2 mol/L.

Gemäß verschiedenen Ausführungsformen kann Chlor als Oxidationsmittel bereitgestellt werden, indem der Ätzlösung 504 Chlorgas oder zumindest ein chlorhaltiges Gas zugeführt wird. Das Gas kann beispielsweise mit einem Volumenstrom in einem Bereich von ungefähr 0,1 L/min bis ungefähr 10 L/min zugeführt werden. Durch Einstellen oder Regeln des Volumenstroms des Gases (z.B. des Chlorgases) können/kann die Abtragsrate und/oder die erzeugte Oberflächenmorphologie beeinflusst werden.

Alternativ kann der Ätzlösung 504 mindestens ein Feststoff zugesetzt sein oder werden, z.B. Hypochlorit, Chlorat, Perchlorat oder ein chloridhaltiges Salz (wie z.B. Natriumchlorid (NaCl), Kaliumchlorid (KCl) und/oder Ammoniumchlorid (NH₄Cl)). Der Feststoff kann sich in der Lösung beispielsweise auflösen und/oder im Kontakt mit der Lösung beispielsweise zerfallen und/oder reagieren und dabei Chlor oder Chlorid freigeben und so als Chlorquelle wirken. Je nachdem welche Oberflächenmorphologie erzeugt werden soll, kann ein passender Feststoff zugeführt werden, welcher eine bestimmte Menge an Chlor oder Chlorid freigibt. Beispielsweise können mittels Zugabe von Hypochlorit oder Perchlorat geringe Abtragsraten erzielt werden. Alternativ oder in Kombination können mehrere Feststoffe zugegeben werden.

Gemäß verschiedenen Ausführungsformen kann das Ätzen des Siliziumwafers 202 bei folgenden weiteren Verfahrensparametern durchgeführt werden:
- Behandlungsdauer t = 30 min, t = 60 min oder t = 120 min, z.B. mit einer Behandlungsdauer in einem Bereich von ungefähr 10 min bis ungefähr 240 min, z.B. in einem Bereich von ungefähr 20 min bis ungefähr 150 min;
- Behandlungstemperatur ϑ = 20 °C, ϑ = 25 °C oder ϑ = 30 °C, z.B. mit einer Behandlungstemperatur in einem Bereich von ungefähr 15 °C bis ungefähr 35 °C.

Gemäß verschiedenen Ausführungsformen können die Verfahrensparameter derart ausgewählt werden, dass eine Oberflächenstruktur 204 auf dem Siliziumwafer 202 geätzt wird, welche einen minimalen Reflexionsgrad bzw. einen maximalen Absorptionsgrad für Licht aufweist.

Gemäß verschiedenen Ausführungsformen kann der Ätzlösung 504 eine oberflächenaktive Substanz (Komponente), z.B. aus der Gruppe der Tenside, zugesetzt sein oder werden.

Als Siliziumwafer 202 können beispielsweise as-cut Diamantdraht-gesägte, as-cut SiC-Slurry-gesägte, vorgereinigte, vortexturierte oder vorpolierte Silizium(100)-Wafer verwendet werden. Der Siliziumwafer 202 kann dotiert sein, z.B. n-dotiert oder p-dotiert.

Die hierin beschriebenen Konzentrationen der Ätzlösung 504 (angegeben in Mol pro Liter; mol/L) können beispielsweise rechnerisch anhand der Masse der Mischungskomponenten ermittelt werden. Ferner können die Konzentrationen von beispielsweise Fluorid-, Chlorid-, bzw. Sulfat-Ionen mittels Ionenaustauschchromatographie ermittelt werden, z.B. mittels eines Dionex ICS 2000.

Die Geometrie bzw. Größe und Verteilung der Vertiefungen der Oberflächenstruktur 204 können beispielsweise mittels eines Rasterelektronenmikroskops (REM) ermittelt werden, vgl. Fig.3A, z.B. mittels eines Vega Tescan TS 5130 SB Systems.

Der Reflexionsgrad eines strukturgeätzten Siliziumwafers 202 kann mittels einer Reflexionsmessung ermittelt werden, z.B. mittels eines Jasco UV/VIS Spektrometers, wobei über eine Kugelfläche integriert wird, und wobei der Siliziumwafer derart relativ zur Lichtquelle des Spektrometers angeordnet ist, so dass das Licht der Lichtquelle senkrecht auf die Oberfläche 202a des Siliziumwafers 202 auftrifft. Als Referenzwellenlänge kann beispielsweise 700 nm verwendet werden. Alternativ kann der Reflexionsgrad auch über den Wellenlängenbereich des sichtbaren Lichts (z.B. von 400 nm bis 700 nm) gemittelt werden.

Der Ätzprozess kann beispielsweise dadurch beendet werden, dass der Siliziumwafer 202 aus der Ätzlösung 504 heraus genommen wird und mit deionisiertem Waser gespült wird.

Gemäß verschiedenen Ausführungsformen wird eine Struktur auf einer Oberfläche von einem monokristallinen oder quasimonokristallinen Siliziumwafer erzeugt zur Erhöhung dessen Lichtabsorptionsgrad, wobei die Struktur zufällig angeordnete inverse Pyramiden aufweist.

Gemäß verschiedenen Ausführungsformen kann die Behandlungstemperatur während des Ätzens geringer sein als 30°C. Anschaulich ist bei dem Verfahren kein Erwärmen der Ätzlösung während des Ätzens notwendig. Beispielsweise kann das Verfahren untemperiert bei Raumtemperatur durchgeführt werden.

Dazu wird die Oberfläche einem anisotropen, nasschemischen Ätzprozess unterworfen. Als Ätzlösung wird ein Gemisch verwendet aufweisend oder bestehend aus Flusssäure (HF), Salzsäure (HCl) und einem zugesetzten Oxidationsmittel. Die Ätzlösung kann als zugesetztes Oxidationsmittel Wasserstoffperoxid enthalten. Die Ätzlösung kann als zugesetztes Oxidationsmittel gasförmiges Chlor enthalten. Die Ätzlösung kann als zugesetztes Oxidationsmittel Kupferionen (Cu²⁺) enthalten. Die Ätzlösung wird in Strömung versetzt und der zu behandelnde Siliziumwafer wird in die Strömung platziert.

Beispielsweise kann ein Flusssäure/Salzsäure-Gemisch als Ätzlösung verwendet werden. In ähnlicher Weise kann gasförmiges Chlor in eine flusssäurehaltige Ätzlösung eingeleitet werden und, in wässriger Lösung zu Salzsäure und hypochloriger Säure disproportioniert, ein Flusssäure/Salzsäure-Gemisch bilden. Dabei kann das gasförmige Chlor gleichzeitig als Oxidationsmittel fungieren.

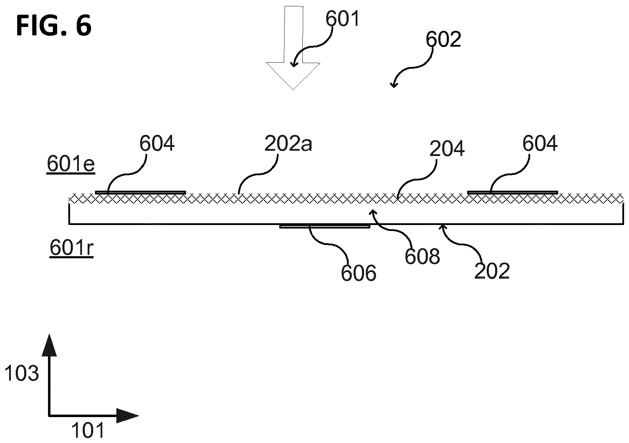

In **Fig.6** ist eine Solarzelle 602 in einer schematischen Querschnittsansicht dargestellt, gemäß verschiedenen Ausführungsformen. Die Solarzelle 602 kann beispielsweise einen Siliziumwafer 202 aufweisen, wie vorangehend beschrieben ist, siehe Fig.2A. In der Funktion als Solarzelle kann der Siliziumwafer 202 entsprechend dotiert sein, so dass in dem Siliziumwafer 202 mindestens ein entsprechend ausgestalteter p-n-Übergang 608 bereitgestellt ist. Zum elektrischen Kontaktieren des Siliziumwafers 202 wird beispielsweise eine Vorderseitenmetallisierung 604 zum elektrischen Kontaktieren der Lichteinfallsseite 601e des Siliziumwafers 202 verwendet sowie eine Rückseitenmetallisierung 606 zum elektrischen Kontaktieren einer der Lichteinfallsseite gegenüberliegenden Rückseite 601r des Siliziumwafers 202.

Gemäß verschiedenen Ausführungsformen ist die Solarzelle 602 derart aufgebaut, dass Licht 601 auf die Oberflächenstruktur 204 aus der Vielzahl von zufällig verteilten polyederförmigen Vertiefungen auftreffen kann und somit effizient in elektrische Energie umgewandelt wird.

Es versteht sich, dass die Ausgestaltung der Solarzelle 602 entsprechend den bekannten Designs für monokristalline Solarzellen erfolgen kann. Zum Dotieren des Siliziumwafers 202 und zum Aufbringen der elektrischen Kontakte 604, 606 können übliche Verfahren der Photovoltaik-Industrie verwendet werden, beispielsweise thermische Diffusion oder Ähnliches zum Dotieren des Siliziumwafers 202 und Löten, Siebdruckverfahren oder Ähnliches zum Aufbringen der elektrischen Kontakte 604, 606.

## Patentansprüche

1. Verfahren zum Strukturieren eines Siliziumwafers (202), das Verfahren aufweisend:
• Platzieren des Siliziumwafers (202) in einer Ätzlösung, wobei der Siliziumwafer eine freiliegende {100}-orientierte Oberfläche (202a) aufweist;
• Erzeugen einer Strömung der Ätzlösung relativ zu der freiliegenden {100}-orientierten Oberfläche (202a) des Siliziumwafers (202) derart, dass eine Oberflächenstruktur (204) aus einer Vielzahl von zufällig verteilten Vertiefungen geätzt wird, wobei die Vertiefungen polyederförmig sind,
wobei die Ätzlösung Flusssäure und Salzsäure enthält sowie ein Oxidationsmittel.

2. Verfahren gemäß Anspruch 1,
wobei die Ätzlösung folgende Konzentrationen an Flusssäure, Salzsäure und Oxidationsmittel aufweist:
c(HF) = 0,1 bis 10 mol/L,
c(HCl) = 1 bis 12 mol/L und
c(Oxidationsmittel) = 0,05 bis 2 mol/L.

3. Verfahren gemäß Anspruch 1 oder 2,
wobei das Oxidationsmittel mindestens eines aus der folgenden Gruppe von Oxidationsmitteln aufweist:
• Wasserstoffperoxid;
• Chlor;
• Kupferionen Cu²⁺.

4. Verfahren gemäß einem der Ansprüche 1 bis 3,
wobei die Strömung mittels Rührens (516) und/oder Umwälzens (518) der Ätzlösung (504) erzeugt wird.

5. Verfahren gemäß einem der Ansprüche 1 bis 4,
wobei die Strömung mittels Einleitens (508) eines Gases (506) in die Ätzlösung (504) erzeugt wird.

6. Verfahren gemäß einem der Ansprüche 1 bis 5,
wobei die Vertiefungen jeweils zumindest zwei ebene dreieckige Seitenflächen aufweisen.

7. Verfahren gemäß einem der Ansprüche 1 bis 6,
wobei die Vertiefungen pyramidenförmige Ätzgruben sind.

8. Verfahren gemäß einem der Ansprüche 1 bis 7,
wobei die Vertiefungen bezüglich des Orts auf der Oberfläche zufällig verteilt sind.

9. Verfahren gemäß einem der Ansprüche 1 bis 8,
wobei die Vertiefungen bezüglich deren Breite und/oder Tiefe zufällig verteilt sind.

10. Verfahren gemäß einem der Ansprüche 1 bis 9,
wobei die Vertiefungen an der Oberfläche des Siliziumwafers im arithmetischen Mittel eine Breite in einem Bereich von ungefähr 0,1 µm bis ungefähr 20 µm aufweisen.

11. Verfahren gemäß einem der Ansprüche 1 bis 10,
wobei die Vertiefungen im arithmetischen Mittel eine Tiefe in einem Bereich von ungefähr 0,1 µm bis ungefähr 20 µm aufweisen.

12. Verfahren gemäß einem der Ansprüche 1 bis 11,
wobei die Anzahl der Vertiefungen pro Quadratmillimeter größer ist als 500.

## Claims

1. Method of structuring a silicon wafer (202), the method comprising:
• Placing the silicon wafer (202) in an etching solution, wherein the silicon wafer comprises an exposed {100}-oriented surface (202a);
• Generating a flow of the etching solution relative to the exposed {100}-oriented surface (202a) of the silicon wafer (202) such that a surface structure (204) of a plurality of randomly distributed recesses is etched, wherein the recesses are polyhedral-shaped, wherein the etching solution contains hydrofluoric acid and hydrochloric acid as well as an oxidizing agent.

2. The method according to claim 1,
wherein the etching solution comprises the following concentrations of hydrofluoric acid, hydrochloric acid, and oxidizing agent:
c(HF) = 0.1 to 10 mol/L,
c(HCl) = 1 to 12 mol/L and
c(oxidizing agent) = 0.05 to 2 mol/L.

3. The method according to claim 1 or 2,
wherein the oxidizing agent comprises at least one oxidizing agent from the following group of oxidizing agents:
• hydrogen peroxide;
• chlorine;
• copper ions Cu²⁺.

4. The method according to any one of claims 1 to 3,
wherein the flow is generated by stirring (516) and/or circulating (518) the etching solution (504).

5. The method according to any one of claims 1 to 4,
wherein the flow is generated by introducing (508) a gas (506) in the etching solution (504).

6. The method according to any one of claims 1 to 5,
wherein each of the recesses comprises at least two flat triangular side surfaces.

7. The method according to any one of claims 1 to 6,
wherein the recesses are pyramid-shaped etch pits.

8. The method according to any one of claims 1 to 7,
wherein the recesses are randomly distributed with respect to the location on the surface.

9. The method according to any one of claims 1 to 8,
wherein the recesses are randomly distributed with respect to their width and/or depth.

10. The method according to any one of claims 1 to 9,
wherein the recesses comprise, in arithmetic average, a width on the surface of the silicon wafer in a range from about 0.1 µm to about 20 µm.

11. The method according to any one of claims 1 to 10,
wherein the recesses comprise, in arithmetic average, a depth in a range from about 0.1 µm to about 20 µm.

12. The method according to any one of claims 1 to 11,
where the number of recesses per square millimeter is greater than 500.

## Revendications

1. Procédé pour structurer une plaquette de silicium (202), le procédé présentant :
• le placement de la plaquette de silicium (202) dans une solution d'attaque, dans lequel la plaquette de silicium présente une surface (202a) exposée orientée {100} ;
• la production d'un écoulement de la solution d'attaque par rapport à la surface (202a) exposée orientée {100} de la plaquette de silicium (202), de telle sorte qu'une structure superficielle (204) composée d'une pluralité d'évidements répartis de manière aléatoire est gravée, dans lequel les évidements sont polyédriques, dans lequel la solution d'attaque contient de l'acide fluorhydrique et de l'acide chlorhydrique ainsi qu'un oxydant.

2. Procédé selon la revendication 1,
dans lequel la solution d'attaque présente les concentrations suivantes d'acide fluorhydrique, d'acide chlorhydrique et d'oxydant :
c (HF) = 0,1 à 10 mol/L,
c (HCl) = 1 à 12 mol/L, et
c (oxydant) = 0,05 à 2 mol/L.

3. Procédé selon la revendication 1 ou 2,
dans lequel l'oxydant présente au moins un du groupe suivant d'oxydants :
• peroxyde d'hydrogène ;
• chlore ;
• ions de cuivre Cu²⁺.

4. Procédé selon l'une quelconque des revendications 1 à 3, dans lequel l'écoulement est produit au moyen d'une agitation (516) et/ou circulation (518) de la solution d'attaque (504).

5. Procédé selon l'une quelconque des revendications 1 à 4,
dans lequel l'écoulement est produit par introduction (508) d'un gaz (506) dans la solution d'attaque (504).

6. Procédé selon l'une quelconque des revendications 1 à 5, dans lequel les évidements présentent respectivement au moins deux surfaces latérales triangulaires plates.

7. Procédé selon l'une quelconque des revendications 1 à 6, dans lequel les évidements sont des puits de gravure pyramidaux.

8. Procédé selon l'une quelconque des revendications 1 à 7, dans lequel les évidements sont répartis de manière aléatoire sur la surface en ce qui concerne le lieu.

9. Procédé selon l'une quelconque des revendications 1 à 8, dans lequel les évidements sont répartis de manière aléatoire en ce qui concerne leur largeur et/ou profondeur.

10. Procédé selon l'une quelconque des revendications 1 à 9, dans lequel les évidements présentent sur la surface de la plaquette de silicium en moyenne arithmétique une largeur dans une plage d'environ 0,1 µm à environ 20 µm.

11. Procédé selon l'une quelconque revendications 1 à 10, dans lequel les évidements présentent en moyenne arithmétique une profondeur dans une plage d'environ 0,1 µm à environ 20 µm.

12. Procédé selon l'une quelconque des revendications 1 à 11, dans lequel le nombre d'évidements par millimètre carré est supérieur à 500.
